Europäisches Patentamt

**European Patent Office**

Office européen des brevets

(11) Veröffentlichungsnummer: **0 310 863 B1**

(12) **EUROPÄISCHE PATENTSCHRIFT**

(45) Veröffentlichungstag der Patentschrift: **10.06.92**

(51) Int. Cl.⁵: **H03L 1/02**

(21) Anmeldenummer: **88115486.8**

(22) Anmeldetag: **21.09.88**

(54) **Verfahren zur Temperaturkompensation eines spannungsgesteuerten Ouarzoszillators in einem Phasenregelkreis.**

(30) Priorität: **28.09.87 DE 3732627**

(43) Veröffentlichungstag der Anmeldung:
**12.04.89 Patentblatt 89/15**

(45) Bekanntmachung des Hinweises auf die
Patenterteilung:
**10.06.92 Patentblatt 92/24**

(84) Benannte Vertragsstaaten:
**AT BE CH DE ES FR IT LI NL**

(56) Entgegenhaltungen:
**US-A- 3 465 127**
**US-A- 4 513 259**

**PATENT ABSTRACTS OF JAPAN, Band 9, Nr. 315 (E-365)[2038], 11. Dezember 1985; & JP-A-60-149 223 (YAESU MUSEN K.K.) 06-08-1985**

**ENGINEER'S NOTEBOOK, Band 45, Nr. 7, 14. August 1972, Seiten 124-126, New York, US; J. WILLEM et al.: "Digital ICs set temperature compensation for oscillators"**

**PATENT ABSTRACTS OF JAPAN, Band 9, Nr. 257 (P-396)[1980], 15. Oktober 1985; & JP-A-60 107 117 (TATEISHI DENKI K.K.)**

**12-06-1985**

**IEEE TRANSACTIONS ON COMMUNICA-TIONS, Band Com-31, Nr. 12, Dezember 1983, Seiten 1295-1303, IEEE, New York, US; H. FU-KINUKI et al.: "Intelligent PLL using digital processing for network synchronization"**

(73) Patentinhaber: **SIEMENS AKTIENGESELL-SCHAFT**
**Wittelsbacherplatz 2**
**W-8000 München 2(DE)**

(72) Erfinder: **Zwack, Eduard, Dipl.-Ing. FH**
**Lochhauserstrasse 86**
**W-8039 Puchheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

In digitalen Fernmeldenetzen sind die einzelnen Systemkomponenten, wie Vermittlungs- und Übertragungseinrichtungen mit Taktgeneratoren ausgestattet. Mit diesen Taktgeneratoren wird die zeitgerechte Steuerung der internen Prozeduren der Systemkomponenten durchgeführt. Um Frequenzsynchronismus zwischen den einzelnen Systemkomponenten zu erreichen, werden von einer zentralen, hochgenauen Takteinrichtung erzeugte Taktinformationen über die vorhandenen Übertragungsstrecken und Übertragungseinrichtungen an die Systemkomponenten übermittelt und zur Synchronisation der implementierten Taktgeneratoren verwendet. Derartige Frequenzsynchronisationseinrichtungen sind als Phasenfrequenzregelkreise - im weiteren mit PLL(Phase-Locked Loop)-Einrichtung bezeichnet - bekannt. Eine PLL-Einrichtung enthält im wesentlichen einen spannungsgesteuerten Oszillator sowie einen Phasenvergleicher mit nachgeschaltetem Filter, der die Ausgangssignale des Oszillators mit den Taktinformationen hinsichtlich ihrer Phase vergleicht und den Oszillator in Abhängigkeit von dem Vergleichsergebnis steuert. Der Oszillator wird überwiegend als Quarzoszillator realisiert, wobei die Eigenschaften des Quarzes, die die Genauigkeit eines Oszillators wesentlich beeinflussen, zu berücksichtigen sind. Im einzelnen sind dies seine Temperaturabhängigkeit und die Veränderung der Quarzeigenschaften, die durch Alterung hervorgerufen werden. Die Temperaturabhängigkeit des Quarzes ist darin zu sehen, daß durch die Umgebungstemperatur verursachte Temperaturschwankungen des Quarzes Frequenzabweichungen des Oszillators hervorrufen. Die Frequenzabweichungen in Abhängigkeit von der Quarztemperatur sind in Temperaturgangkurven festgelegt, die jedem Quarz fest zugeordnet sind. Die Temperaturabhängigkeit des Quarzes hängt im wesentlichen von der Art des Quarzschnittes ab, d.h. dem Winkel gegenüber einer Kristallachse, unter dem der Quarz aus dem Quarzkristall herausgeschnitten wird. Da der Frequenzbereich der PLL-Einrichtungen in digitalen Fernmeldenetzkomponenten meist über 1 Mhz liegt, werden Quarze mit sogenannten "AT-Schnitten" eingesetzt. Es sind nun Verfahren bekannt, mit denen die Frequenzabweichungen, die durch Temperaturschwankungen hervorgerufen werden, kompensierbar sind. Ein derartiges Verfahren ist in der ZVEI-Druckschrift, Schwingquarze, ein unverzichtbares Bauelement in der Elektronik, Tagungsdokumentation Quarz-Symposium '85 beschrieben. Hierbei wird der Quarz mit einem Temperatursensor einer Temperaturmeßeinrichtung thermisch gekoppelt. Die analog vorliegenden Meßwerte werden in einem A/D-Wandler digitalisiert und einem Speicher, in dem die zur Kompensation erforderlichen Spannungswerte in digitaler Form gespeichert sind, zugeführt. Jedem digitalisierten Meßwert ist ein digitaler Kompensationswert zugeordnet, der nach einer D/A-Wandlung als analoge Kompensationsspannung an den Spannungssteuereingang des Oszillators gelangt und eine Korrektur der temperaturbedingten Frequenzabweichungen bewirkt. Mit diesem digitalen Kompensationsverfahren können somit die durch Temperaturschwankungen hervorgerufenen Frequenzabweichungen des Oszillators kompensiert werden.

Ein derartig aufgebauter Oszillator kann auch in einer PLL-Einrichtung eingesetzt werden. Hierbei ist es als besonders vorteilhaft anzusehen, den Speicher durch eine mit einem Speicher ausgestattete Prozessoreinrichtung zu ersetzen, da neben der Temperaturkompensation des Quarzes eine Korrektur des Oszillators einzubeziehen ist, die aufgrund der Frequenzabweichungen beziehungsweise Phasenabweichungen der beiden Taktsignale notwendig ist.

Des weiteren ist bekannt, nicht jedem durch den A/D-Wandler bestimmten Temperaturschritt einen Kompensationswert im Speicher zuzuordnen. Innerhalb eines ausgewählten Betriebstemperaturbereiches - zum Beispiel -20° bis +70° - werden für eine ausgewählte Anzahl von Quarztemperaturen die entsprechenden Kompensationswerte gespeichert. Die Anzahl der Quarztemperaturen, für die Kompensationswerte gespeichert sind, richtet sich beispielsweise nach der Krümmung der Temperaturgangkurve des Quarzes, da für die zwischen den ausgewählten Quarztemperaturen liegenden aktuell gemessenen Quarztemperaturen die Kompensationswerte durch lineare Interpolation - erfordert bei starken Krümmungen der Temperaturgangkurve mehr ausgewählte Quarztemperaturen, um die Interpolationsfehler niedrig zu halten - berechnet werden. Hierbei ist für jede durch den A/D-Wandler bestimmte Spannungsstufe der jeweilige Zwischenwert zu berechnen.

Die Aufgabe der Erfindung besteht darin, ein Verfahren so auszugestalten, daß sowohl die speicherplatzintensive Speicherung von Kompensationswerten je A/D-Wandler-Spannungsstufe als auch die rechnerintensive lineare Interpolation vermieden werden. Die Aufgabe wird, ausgehend von den eingangs beschriebenen Verfahren durch die kennzeichnenden Merkmale des Anspruchs 1 gelöst.

Der wesentliche Erfindungsgedanke ist darin zu sehen, daß der Quarz des Quarzoszillators mittels einer Heiz- bzw. Kühleinrichtung auf eine der beiden ausgewählten Quarztemperaturen gebracht wird, die der Umgebungstemperatur am nächsten liegen. Hierdurch wird bewirkt, daß bei Ausfall der Referenztaktsignale die gespeicherten Kompensationswerte für die ausgewählten Quarztemperaturen ohne zusätzliche Berechnungen beziehungsweise Interpolationen direkt zum Bilden der Ansteuerspannung für den spannungsgesteuerten Quarzoszillator verwendbar sind. Mittels des erfindungsgemäßen Verfahrens werden die Vorteile der Temperaturkompensationsmethode - Bilden von Kompensationswerten - und die Vorteile eines beheizbaren Oszillators - Konstanthalten des Quarzes auf einer vorgegebenen Temperatur - in idealer Weise genutzt, die Nachteile der Temperaturkompensation - hoher Speicherbedarf zur Speicherung aller Kompensationswerte oder erhebliche Rechnerleistungen bei Interpolationsverfahren - und die Nachteile des beheizbaren Quarzes - enormer Energieverbrauch durch Heizen über den Betriebstemperaturbereich hinaus - jedoch vermieden.

Ein weiterer Vorteil der Erfindung besteht darin, daß bei Inbetriebnahme des Quarzoszillators eine minimale Aufheiz- bzw. Kühlzeit erforderlich ist, um den Quarzoszillator auf die nächstgelegene, ausgewählte Quarztemperatur zu steuern, wodurch der Zeitraum, in dem der Quarzoszillator größere Frequenzabweichungen aufweisen kann, möglichst klein gehalten wird.

Des weiteren sollen bei Einsatz des Quarzoszillators in einem Phasenregelkreis die Kompensationswerte, die der Temperaturkompensation des Quarzes dienen, hinsichtlich des Spannungswertes möglichst klein gehalten werden, um möglichst große Frequenzabweichungen der Oszillatorsignale zu den Referenztaktsignalen ausgleichen zu können. Es wird daher vorzugsweise ein Quarz ausgewählt, bei dem innerhalb eines vorgegebenen Betriebstemperaturbereiches eine geforderte Frequenzabweichung nicht überschritten wird - siehe Anspruch 2 -. Überwiegend sind dies Quarze mit 'AT-Schnitten' von 2 bis 4 Grad.

Aufgrund der schnellen Alterung von Quarzen ergeben sich erhebliche Veränderungen der Frequenzgangkurven, die eine Aktualisierung der Kompensationswerte wünschenswert erscheinen lassen. Ein weiterer Vorteil der Erfindung ist nun darin zu sehen, daß die Kompensationswerte während des Betriebes für die ausgewählten Quarztemperaturen aktualisierbar sind. Zur Ermittlung der aktuellen Kompensationswerte sind zwei während des Betriebes häufig auftretende Zustandsbedingungen erforderlich. Zu einem ist dies das Vorhandensein der Referenztaktsignale und zum anderen eine Übereinstimmung der Phasenlage der Referenztakt- mit den Oszillatorsignalen. Liegen beide Voraussetzungen vor, so stellt die digitalisierte Ansteuerspannung des spannungsgesteuerten Quarzoszillators den aktuellen Kompensationswert für die aktuell ausgewählte Quarztemperatur dar. Dieser ermittelte Kompensationswert wird als aktueller Kompensationswert, in den nun die Änderungen aufgrund der Quarzalterung einbezogen sind, in denjenigen Speicherbereich gespeichert, der jeweils der aktuell ausgewählten Quarztemperatur zugeordnet ist. Aufgrund der sich ändernden Umgebungstemperatur werden während des Betriebes unterschiedliche ausgewählte Quarztemperaturen eingestellt, für die dann jeweils unter vorgenannten Bedingungen ein aktueller Kompensationswert ermittelt und abgespeichert wird.

Mit Hilfe eines Peltier-Elementes kann sowohl eine Heiz- als auch eine Kühlwirkung erzielt werden. Die Kühl- oder Heizwirkung hängt von der Stromrichtung durch das Peltier-Element und die Intensität von der Stromstärke ab. Mit Hilfe dieses Peltier-Elements kann die ausgewählte Quarztemperatur eingestellt werden, die der Umgebungstemperatur des Quarzoszillators am nächsten liegt. Dies bedeutet, daß mit minimaler Leistung, d.h. Heiz- oder Kühlleistung, eine ausgewählte Quarztemperatur eingestellt werden kann.

Anstelle einer Heiz- bzw. Kühleinrichtung ist das erfindungsgemäße Verfahren auch mit einer einfachen Heizeinrichtung realisierbar. Beispielsweise kann als Heizeinrichtung ein Transistor vorgesehen werden. Bei Einsatz einer Heizeinrichtung muß die Prozessoreinrichtung mit Hilfe der Temperaturmeßeinrichtung die Heizeinrichtung derart steuern, daß der Quarz die der Umgebungstemperatur nächsthöhere ausgewählte Temperatur aufweist - Anspruch 5 -. Diese Ausgestaltung ist zwar mit geringstem Aufwand zu realisieren, bedingt jedoch einen durchschnittlich etwas höheren Leistungsverbrauch, der jedoch durch Erhöhen der Anzahl von ausgewählten Quarztemperaturen wieder verringert werden kann.

Ein weiterer wesentlicher Vorteil der Erfindung liegt in der einfachen erstmaligen Ermittlung der Kompensationswerte des Quarzes. Hierbei wird der Quarz mittels der Heiz- bzw. Kühleinrichtung - als Peltier-Element realisiert - auf eine ausgewählte - sinnvollerweise mit der höchsten oder niedrigsten beginnend - Quarztemperatur gebracht. Nach Erreichen einer ausgewählten Quarztemperatur werden hochkonstante Referenztaktsignale mit den Quarzoszillatorsignalen verglichen. Die Quarzoszillatoransteuerspannung wird nun solange verändert, bis die Frequenz der Referenztaktsignale und der Oszillatorsignale gleich ist. Die zuletzt erreichte Quarzoszillatoransteuerspannung stellt für die ausgewählte Quarztemperatur den zugehörigen Kompensationswert dar. Dieser Kompensationswert wird in jeweils einem der ausgewählten Quarztemperaturen zugeordneten Speicherbereiche der Prozessoreinrichtung gespeichert. Dieser Vorgang wird für die weiteren ausgewählten Quarztemperaturen analog durchgeführt - Anspruch 6 -. Sollte die Heiz- bzw. Kühlwirkung des eingesetzten Peltier-Elements nicht ausreichen, so kann ein weiteres leistungsstarkes Peltier-Element thermisch in Reihe geschaltet werden. Durch das direkte Beheizen bzw. Kühlen des Quarzes werden Verhältnisse geschaffen, wie sie während des späteren Betriebes des Oszillators vorliegen. Des weiteren wird der Einsatz teurer Klimaschränke vermieden, bei denen zudem der Quarzoszillator von außen her beheizt oder gekühlt wird, wodurch Betriebsverhältnisse hinsichtlich Temperaturerzeugung und -verteilung geschaffen werden, die nicht exakt den späteren Betriebsverhältnissen entsprechen.

Im folgenden wird die Erfindung anhand von Zeichnungen näher erläutert. Dabei zeigen

FIG 1    Ein Diagramm, in dem die Temperaturabhängigkeit der Frequenz von Quarzen mit "AT-Schnitt" dargestellt ist und

FIG 2    Ein Blockschaltbild eines Phasenregelkreises.

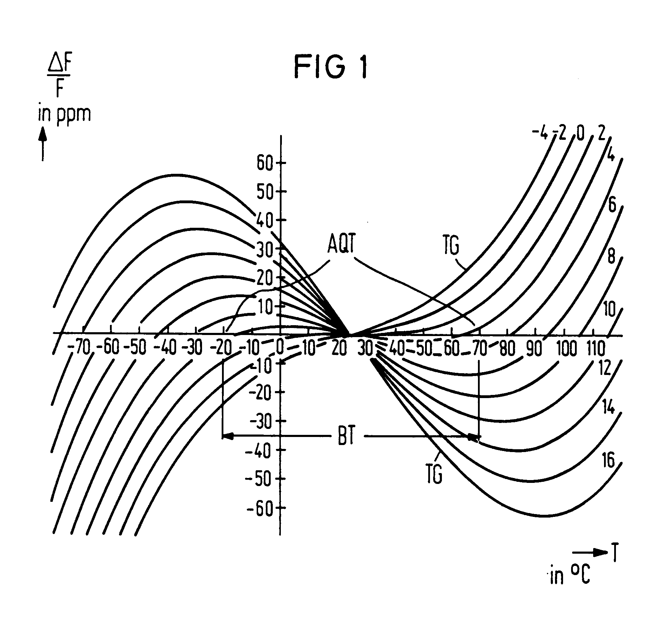

Figur 1 zeigt mehrere Temperaturgangkurven TG von Quarzen mit "AT-Schnitt". Die Temperaturgangkurven TG sind in einem X/Y-Koordinatensystem dargestellt, wobei die X-Achse die Temperaturänderungen T des Quarzes in Grad Celsius °C und auf der Y-Achse die Frequenzabweichungen $\Delta$ F von der Nennfrequenz F des Quarzes in PPM(parts per million) angegeben sind. Für das Ausführungsbeispiel sei ein Betriebstemperaturbereich BT von -20°C bis +70°C angenommen. Bei Einsatz eines Quarzes in einem Phasenregelkreis ist ein Quarz auszuwählen, dessen maximale Frequenzabweichungen $\Delta$ F in einem vorgegebenen Betriebstemperaturbereich BT am geringsten sind. Wie aus Figur 1 ersichtlich, kommt die Temperaturgangkurve TG eines Quarzes mit einem 'AT-Schnitt' von 2 Grad den geforderten Bedingungen am nächsten. Des weiteren sei für das Ausführungsbeispiel angenommen, daß die ausgewählten Quarztemperaturen AQT in 5°C-Schritten regelmäßig über den Betriebstemperaturbereich BT verteilt sind. Somit ergeben sich neunzehn zu speichernde Kompensationswerte.

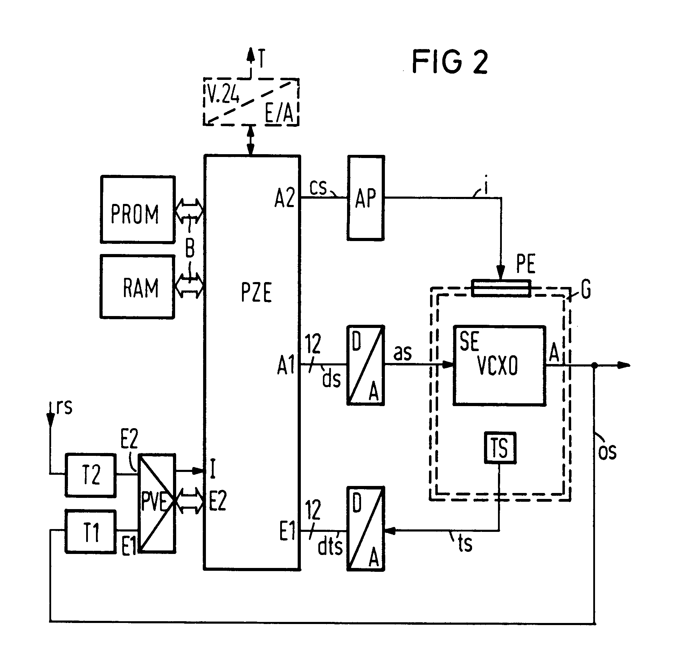

Ein nach Figur 1 ausgewählter Quarz ist nun in einem in Figur 2 dargestellten spannungsgesteuerten Quarzoszillator VCXO enthalten. Dieser spannungsgesteuerte Oszillator VCXO besteht beispielsweise aus einer integrierten Oszillatorschaltung, aus dem ausgewählten Quarz sowie einer Ziehschaltung, mit der die Oszillatorfrequenz in vorgegebenen Grenzen regelbar ist. Da die Ziehschaltung im wesentlichen durch Kapazitätsdioden realisiert ist, wird eine Frequenzänderung durch Variieren einer Gleichspannung, die an einen Spannungseingang SE des spannungsgesteuerten Quarzoszillators VCXO angelegt wird, erreicht. Der spannungsgesteuerte Quarzoszillator VCXO - im weiteren mit Oszillator VCXO bezeichnet - ist zusammen mit einem Temperatursensor TS in einem Metallgehäuse G untergebracht. An einer der Außenseiten dieses Metallgehäuses G ist ein Peltier-Element PE formschlüssig angeordnet. Die restlichen Außenseiten des Metallgehäuses G sind mit einer Wärmeisolierung versehen, um ein Abstrahlen der im Metallgehäuse vorhandenen Wärme bzw. Kühle zu vermeiden. Die Heiz- bzw. Kühlleistung des Peltier-Elements PE ist ausgehend von den ausgewählten 5°C Quarztemperaturschritten so zu bemessen, daß im Metallgehäuse G eine maximale Temperaturdifferenz von ±3°C zur Umgebungstemperatur bewirkt wird. Sowohl der Steuereingang SE des Oszillators VCXO als auch die Ausgänge des Temperatursensors TS sind jeweils mit einer Analog-Digital-Umsetzeinrichtung D/A verbunden. Hierbei werden die vom Temperatursensor TS kommenden analogen Temperaturmeßsignale ts in digitale Temperaturmeßsignale dts umgesetzt und einem hierfür vorgesehenen Eingang E1 einer Prozessoreinrichtung PZE zugeführt. In der zweiten Analog-Digital-Umsetzeinrichtung D/A werden die von in der Prozessoreinrichtung PZE digitalisierten Spannungssignale ds in analoge Spannungssignale as umgesetzt und dem Steuerspannungseingang SE des Oszillators VCXO zugeführt. Die elektrischen Ausgänge des Peltier-Elements PE sind zu einer ebenfalls mit der Prozessoreinrichtung PZE verbundenen Anpassungseinrichtung AP geführt. In dieser werden von der Proezessoreinrichtung PZE kommenden digitalen Steuersignale cs in analoge Stromflüsse i umgesetzt und je nachdem, ob eine Heiz- oder Kühlwirkung erzielt werden soll, die entsprechende Stromrichtung und die Intensität durch eine entsprechende Stromstärke eingestellt.

Die am Ausgang A des Oszillators VXO abgegebenen Oszillatorsignale os werden über eine erste Teilereinrichtung T1 zu einem ersten Eingang E1 einer Phasenvergleichseinrichtung PVE geführt. Über eine zweite Teilereinrichtung T2 werden Referenztaktsignale rs an einen zweiten Eingang E2 der Phasenvergleichseinrichtung PVE geführt. Die Referenztaktsignale rs sind beispielsweise aus den empfangenen Informationen einer Übertragungseinrichtung abgeleitet und regeneriert. In der Phasenvergleichseinrichtung PVE werden die Referenztaktsignale rs und die Oszillatorsignale os hinsichtlich ihrer Phase verglichen. Das Vergleichsergebnis gelangt über eine entsprechend angeordnete Verbindung zu einem zweiten Eingang E2 der Prozessoreinrichtung PZE. Der als Mikroprozessor realisierten Prozessoreinrichtung PZE sind zur Speicherung der Betriebssystemprogramme ein PROM (Programmable Read Only Memory) und zur Speicherung von Daten und Anwenderprogrammen ein RAM (Random Access Memory) zugeordnet. Beide Speicher PROM, RAM sind über ein aus Steuer-, Adress- und Datenleitungen gebildetes Bussystem B mit der Prozessoreinrichtung PZE verbunden. Die Prozessoreinrichtung PZE kann beispielsweise mittels des Siemens-Mikroprozessorsystems 8051 realisiert sein. Kerneinheit dieses Mikroprozessorsystems 8051 bildet der 8 Bit - ein Chip - Mikrocomputer 8051. In diesem Mikroprozessor ist neben der Zentraleinheit (CPU-Central Processing Unit) der Taktgeber, die Ein-/Ausgabeeinrichtung sowie ein RAM-Speicher integriert. Die Anpassungseinrichtung AP und die beiden Analog-Digital-Umsetzeinrichtungen D/A sind über die nicht dargestellte Ein-/Ausgabeeinrichtung der Prozessoreinrichtung PZE verbunden. In den Analog-Digital-Umsetzeinrichtungen werden beispielsweise analoge Informationen in 12-Bit-breite, digitale Informationen umgesetzt. Somit sind die Analog-Digital-Umsetzeinrichtungen jeweils über 12 Leitungen mit der Prozessoreinrichtung PZE verbunden. Da die Ein-/Ausgabeeinrichtung der Prozessoreinrichtung PZE nicht derart viele Anschlüsse aufweist, werden die 12 Leitungen über eine nicht dargestellte, von der Prozessoreinrichtung PZE gesteuerte Multiplexeinrichtung, an 12 Eingänge der Ein-/Ausgabeeinrichtung angeschlossen. Um mit der Prozessoreinrichtung PZE über ein externes Terminal kommunizieren zu können, kann diese mit einer V.24-Schnittstelle ausgestattet werden. Hierbei werden bestimmte Ein- bzw. Ausgänge der Ein-/Ausgabeeinrichtung als V.24-Schnittstellenleitungen definiert und über Anpassungseinrichtungen, die die internen TTL-Signale in V.24-gemäße Signale umwandeln, an eine extern angeordnete V.24-Steckverbindung geführt. Für die Realsierung der V.24-Übermittlungsprozedur sowie für die Aufbereitung der Daten - der empfangenen wie zu sendenden Daten ist ein geeignetes Programm - für derartige Mikroprozessorsysteme bereits realisiert - zu implementieren.

Mittels der ersten und zweiten Teilereinrichtung T1, T2 und der Phasenvergleichseinrichtung PVE werden die Referenztaktsignale rs mit den Oszillatorsignalen os hinsichtlich ihrer Phase verglichen und das Vergleichsergebnis über den aus Daten- und Steuerleitungen bestehenden Systembus B an die Prozessoreinrichtung PZE übermittelt. Prinzipiell wird mittels der ersten und zweiten Teilereinrichtung T1, T2 und der Phasenvergleichseinrichtung PVE die Größe der Phasenabweichung hardwaremäßig festgestellt und der Prozessoreinrichtung PZE zu einem bestimmten Zeitpunkt - wird über INTERRUPT-Eingang dem Mikroprozessorsystem PZE mitgeteilt - übermittelt. In der Prozessoreinrichtung PZE wird mittels eines ein PI-Regelglied realisierenden Programms in Abhängigkeit von der Phasenabweichung ein digitales Regelsignal - das den Kompensationswert darstellt - gebildet und über eine Digital-Analog-Umsetzeinrichtung zum Spannungseingang SE des Oszillators VCXO geführt. Dieses Regelsignal wird so bemessen, daß Phasengleichheit zwischen den Referenztaktsignalen rs und den Oszillatorsignalen os erreicht wird. Das Regelsignal wird gleichzeitig in einem der ausgewählten Quarztemperatur zugeordneten Speicherbereich als Kompensationswert gespeichert und bei Ausfall der Referenztaktsignale bei der entsprechend ausgewählten Quarztemperatur zum direkten Ansteuern des Oszillators VCXO verwendet.

Mittels des Temperatursensors TS - beispielsweise durch einen Halbleitertemperatursensor und einer analogen Anpassungsschaltung realisiert - wird die Temperatur innerhalb des Metallgehäuses G gemessen und über die Analog-Digital-Umsetzeinrichtung A/D der Prozessoreinrichtung PZE zugeführt. Bei der Inbetriebnahme des Oszillators VCXO wird die Oszillatortemperatur der Umgebungstemperatur des Phasenregelkreises entsprechen. Beispielsweise sei dies +22°C. Aufgrund der ausgewählten Quarztemperaturen - wie eingangs in 5°C-Schritten innerhalb des Betriebstemperaturbereiches definiert - liegt die ausgewählte Quarztemperatur +20°C der aktuell gemessenen Temperatur am nächsten. Die Prozessoreinrichtung PZE steuert zusammen mit der Anpassungseinrichtung AP das Peltier-Element PE derart, daß eine Kühlwirkung erzielt wird. Der Oszillator VCXO wird solange gekühlt, bis die ausgewählte Quarztemperatur von +20°C erreicht wird. Diese eingestellte, ausgewählte Quarztemperatur wird durch entsprechende Ansteuerung des Peltier-Elementes PE konstant gehalten, solange eine zulässige Stromstärke durch das Peltier-Element PE, die ein Steigen oder Fallen der Umgebungstemperatur anzeigt, nicht überschritten wird. Steigt die Umgebungstemperatur beispielsweise auf +24°C an, so muß das den Oszillator VCXO beinhaltende Gehäuse G um 4°C gekühlt werden. Dies bedeutet eine Stromstärke durch das Peltier-Element PE, die überhalb einer zulässigen Stromstärke liegt, mit der das Gehäuse G maximal um ±3°C, ausgehend von der aktuell ausgewählten Quarztemperatur, beheizt oder gekühlt wird. Aufgrund des Überschreitens der zulässigen Stromstärke zum Kühlen des Gehäuses G wird nun das Peltier-Element PE derart angesteuert, daß die nächsthöher gelegene, ausgewählte Quarztemperatur von 25°C eingestellt wird. Hierdurch fällt die Stromstärke durch das Peltier-Element PE wieder unter einen Wert, der innerhalb des zulässigen Stromstärkebereiches liegt. Dieses Verfahren zur Temperaturregelung des Oszillators ist beispielsweise als Anwenderprogramm in der Prozessoreinrichtung PZE gespeichert. Mit dem erfindungsgemäßen Verfahren wird nun erreicht, daß die Temperaturdifferenz zwischen Umgebungstemperatur und der ausgewählten Quarztemperatur am kleinsten ist und die für die ausgewählten Quarztemperaturen gespeicherten Kompensationswerte bei Ausfall der Referenztaktsignale rs direkt zum Bilden der Ansteuerinformation des Oszillators VCXO verwendbar sind. Diese Ansteuerinformationen ds stellen digitalisierte Spannungswerte dar, die nach einer D/A-Wandlung in einer Digital-Analog-Umsetzeinrichtung dem Oszillator VCXO zugeführt werden.

Die nachfolgende Tabelle enthält beispielhaft Realisierungsmöglichkeiten für die einzelnen Systemkomponenten des Phasenregelkreises:

| | |
|---|---|
| Prozessorsystem PZE | Siemens-Ein-Chip-Mikroprozessor 8051 mit Resetschaltung TL7705, Datenleitungstreiber 74ALS 373 und Adreßleitungstreiber 74ALS 245 der Advanced Low Power Schottky-Schaltkreise |
| Quarzoszillator VCXO (einschließlich Quarz) | 16,384MHz KVG (Kristallverarbeitung Neckarbischofsheim GmbH) |
| Temperaturmeßeinrichtung TS | Temperatursensor AD590 und Instrumentalverstärker AD524 (Fa. Intersil) |
| Digital/Analog-Umsetzeinrichtungen A/D | AD574 und AD667 (Fa. Intersil) |
| Phasenvergleichseinrichtung PVE | 74ALS374 (D-Register) |
| Teilereinrichtungen T1, T2 | 74ALS160 und 74ALS161 (binärer bzw. dekadischer Zähler |
| V.24-Schnittstellenbausteine | SN74188 und SN75189 (Fa. Siemens) |

**Patentansprüche**

1. Verfahren zur Temperaturkompensation eines spannungsgesteuerten Quarzoszillators in einem Phasenregelkreis, wobei die digitalen Ausgangssignale des Quarzoszillators bezüglich ihrer Phase mit digitalen Referenztaktsignalen verglichen und einer mit einem Speicher ausgestatteten Prozessoreinrichtung zugeführt werden, in der in Abhängigkeit von den Phasenvergleichsergebnissen digitale Spannungssignale im Sinne einer Phasen- und Frequenzsynchronisierung der Oszillator- mit den Frequenztaktsignalen gebildet und nach einer Digital-Analog-Wandlung einem Steuereingang des Quarzoszillators zugeführt werden, sowie von einer aktuelle Temperaturen am Quarz ermittelnden Temperaturmeßeinrichtung digitale Meßsignale an die Prozessoreinrichtung geführt werden, in deren Speicher für ausgewählte Quarztemperaturen digitalisierte Kompensationswerte gespeichert sind und bei Ausfall der Referenztaktsignale in Abhängigkeit von der aktuell gemessenen Quarztemperatur mit Hilfe der ausgewählten, gespeicherten Kompensationswerte die digitalen Spannungssignale gebildet werden,
**dadurch gekennzeichnet,**
daß dem spannungsgesteuerten Quarzoszillator (VCXO) eine die Quarztemperatur beeinflussende Heiz- bzw. Kühleinrichtung (PE) zugeordnet ist und die Prozessoreinrichtung (PZE) mit Hilfe der Temperaturmeßeinrichtung (TS) die Heiz- bzw. Kühleinrichtung (PE) derart steuert, daß der Quarz eine vorgegebene der Umgebungstemperatur nächstliegende Temperatur aufweist.

2. Verfahren nach Anspruch 1, **dadurch gekennzeichnet,** daß der Quarz derart ausgelegt ist, daß seine maximale Frequenzabweichung ($\Delta F$) innerhalb eines ausgewählten Betriebstemperaturbereiches (BT) einen geforderten Wert nicht überschreitet.

3. Verfahren nach Anspruch 1,
**dadurch gekennzeichnet,**
daß bei Vorhandensein der Referenztaktsignale (rs) während des Betriebes des Phasenregelkreises die Kompensationswerte bestimmt und jeweils als aktueller Kompensationswert in einen jeweils einer vorgegebenen Quarztemperatur zugeordneten Speicherbereich des Prozessors gespeichert werden.

4. Verfahren nach einem der vorhergehenden Ansprüche,
**dadurch gekennzeichnet,**
daß die Temperatureinrichtung (PE) durch ein Peltier-Element (PE) realisierbar ist, wobei die Stromrichtung eine Kühl- oder Heizwirkung und die Stromstärke deren Intensität bestimmt.

5. Verfahren nach Anspruch 1 oder 2,
**dadurch gekennzeichnet,**
daß die Heiz- bzw. Kühleinrichtung (PE) durch eine Heizeinrichtung realisierbar ist und daß die Prozessoreinrichtung (PZE) mit Hilfe der Temperaturmeßeinrichtung (TS) die Heizeinrichtung derart steuert, daß der Quarz eine vorgegebene, der Umgebungstemperatur nächst höher gelegene Temperatur aufweist.

6. Verfahren nach einem der Ansprüche 1 bis 3,
**dadurch gekennzeichnet,**
daß im Sinne der erstmaligen Ermittlung der Kompensationswerte eines Quarzes dem Phasenregelkreis hochkonstante Referenztaktsignale (RS) zugeführt werden, daß die Quarztemperatur durch eine externe Steuerung der Heiz- bzw. Kühleinrichtung (PE) auf die vorgegebenen Quarztemperaturstufen eingestellt wird, wobei die ermittelten Quarzoszillatoransteuerspannungen die Kompensationswerte für die jeweilige vorgegebene Quarztemperaturstufe darstellen und daß die Kompensationswerte in jeweils einem der vorgegebenen Quarztemperaturen zugeordneten Speicherbereiche gespeichert werden.

7. Einrichtung zum Durchführen des Verfahrens nach den Ansprüchen 1, 2, 3 oder 5,
**dadurch gekennzeichnet,**
daß der spannungsgesteuerte Quarzoszillator (VCXO), das Peltierelement (PE) und der Temperatursensor (TS) in einem thermisch isolierten Gehäuse (G) angeordnet sind, daß die Temperaturmeßeinrichtung (TS) und der Spannungssteuereingang (SSE) des Quarzoszillators (VCXO) über Analog/Digital-Umsetzeinrichtungen (D/A) und das Peltierelement (PE) über eine Anpassungseinrichtung (AP) mit einer Prozessoreinrichtung (PZE) verbunden ist und daß der Quarzoszillatorausgang (A) über eine erste Teilereinrichtung (T1) und die Referenztaktsignale (rs) über eine zweite Teilereinrichtung (T2) an eine mit der Prozessoreinrichtung (PZE) verbundene Phasenvergleichseinrichtung (PV) geführt sind.

**Claims**

1. Method for the temperature compensation of a voltage-controlled quartz oscillator in a phase-locked loop, in which the digital output signals of the quartz oscillator are compared with respect to their phase with digital reference clock signals and are fed to a processor device which is equipped with a memory and in which, depending on the phase comparison results, digital voltage signals are formed for the purpose of a phase and frequency synchronisation of the oscillator signals with the frequency clock signals and, after a digital-analog conversion, are fed to a control input of the quartz oscillator, and also digital measurement signals are fed to the processor device from a temperature measuring device which determines current temperatures at the quartz, in the memory of which processor device digitised compensation values are stored for selected quartz temperatures and the digital voltage signals are formed with the aid of the selected, stored compensation values in the event of failure of the reference clock signals depending on the currently measured quartz temperature, characterised in that a heating and cooling device (PE) which influences the quartz temperature is assigned to the voltage-controlled quartz oscillator (VCXO), and with the aid of the temperature measuring device (TS) the processor device (PZE) controls the heating and cooling device (PE) in such a way that the quartz has a predetermined temperature lying closest to the ambient temperature.

2. Method according to Claim 1, characterised in that the quartz is designed in such a way that its maximum frequency deviation ($\Delta$F) within a selected operating temperature range (BT) does not exceed a prescribed value.

3. Method according to Claim 1, characterised in that in the event of the presence of reference clock signals (rs) during the operation of the phase-locked loop, the compensation values are determined and are stored in each case as the current compensation value in a memory area of the processor assigned to a predetermined quartz temperature in each case.

4. Method according to one of the preceding claims, characterised in that the temperature device (PE) can be realised by a Peltier element (PE), the current direction determining a cooling or heating effect and the current intensity determining the intensity thereof.

5. Method according to Claim 1 or 2, characterised in that the heating or cooling device (PE) can be realised by a heating device, and in that with the aid of the temperature measuring device (TS) the processor device (PZE) controls the heating device in such a way that the quartz has a predetermined temperature lying next closest above the ambient temperature.

6. Method according to one of Claims 1 to 3, characterised in that, for the purpose of determining the compensation values of a quartz for the first time, highly constant reference clock signals (RS) are fed to the phase-locked loop, in that the quartz temperature is set to the predetermined quartz temperature steps by an external control of the heating and cooling device (PE), the quartz oscillator drive voltages determined representing the compensation values for the respective predetermined quartz temperature step, and in that the compensation values are stored in each case in one of the memory areas assigned to the predetermined quartz temperatures.

7. Device for carrying out the method according to Claims 1, 2, 3 or 5, characterised in that the voltage-controlled quartz oscillator (VCXO), the Peltier element (PE) and the temperature sensor (TS) are arranged in a thermally insulated housing (G), in that the temperature measuring device (TS) and the voltage control input (SSE) of the quartz oscillator (VXCO) are connected to a processor device (PFZE) via analog/digital conversion devices (D/A) and the Peltier element (PE) is connected thereto via a matching device (AP), and in that the quartz oscillator output (A) is fed via a first divider device (T1) and the reference clock signals (rs) are fed via a second divider device (T2) to a phase comparison device (PV) connected to the processor device (PZE).

**Revendications**

1. Procédé pour compenser en température un oscillateur à quarts commandé par la tension, dans un circuit de régulation de phase, selon lequel les signaux numériques de sortie de l'oscillateur à quarts sont comparés, quant à leur phase, à des signaux numériques de référence et sont envoyés à un dispositif à processeur pourvu d'une mémoire et dans lequel des signaux numériques de tension sont formés, en fonction des résultats de la comparaison de phase, dans le sens d'une synchronisation de phase et de fréquence des signaux de l'oscillateur sur les signaux de cadence de fréquence, et sont envoyés, après une conversion numérique/ analogique, à l'entrée de commande de l'oscillateur à quarts, et que des signaux de mesure numérique sont envoyés, par un dispositif de mesure de température déterminant les températures actuelles dans le quarts, au dispositif à processeur, dans la mémoire duquel sont mémorisés des valeurs de compensation numérisées pour des températures sélectionnées du quarts, alors qu'en cas de défaillance des signaux de cadence de référence, les signaux de tension numériques sont formés en fonction de la température du quarts actuellement mesurée, à l'aide des valeurs de compensation sélectionnées et mémorisées, caractérisé par le fait qu'à l'oscillateur à quarts (VCXO) commandé par la tension est associé un dispositif de chauffage ou de refroidissement (PE) qui influe sur la température du quartz, et que le dispositif à processeur (PZE) commande, à l'aide du dispositif de mesure (TS), le dispositif de chauffage ou de refroidissement (PE) de telle sorte que le quarts possède une température prédéterminée, qui est la plus proche de la température ambiante.

2. Procédé suivant la revendication 1, caractérisé par le fait que le quarts est agencé de telle sorte que son écart de fréquence maximum (DF) à l'intérieur d'une gamme sélectionnée (BT) de températures de fonctionnement, ne dépasse pas une valeur requise.

3. Procédé suivant la revendication 1, caractérisé par le fait que, dans le cas de la présence des signaux de la cadence de référence (rs) pendant le fonctionnement du circuit de régulation de phase, les valeurs de compensation sont déterminées et mémorisées respectivement en tant que valeurs de compensation actuelles dans une zone de mémoire du processeur, associée respectivement à une température prédéterminée du quartz.

4. Procédé suivant l'une des revendications précédentes, caractérisé par le fait que le dispositif de mise en température (PE) peut être formé par un élément Peltier (PE), le sens du courant déterminant une action de refroidissement ou de chauffage et l'intensité du courant déterminant l'intensité de cette action.

5. Procédé suivant la revendication 1 ou 2, caractérisé par le fait que le dispositif de chauffage ou de refroidissement (PE) peut être formé par un dispositif de chauffage et que le dispositif à processeur (PZE) commande, à l'aide du dispositif de mesure de température (TS), le dispositif de chauffage de sorte que le quarts possède une température prédéterminée, qui est directement supérieure à la température ambiante.

6. Procédé suivant l'une des revendications 1 à 3, caractérisé par le fait qu'en vue de déterminer pour la première fois les valeurs de compensation d'un quarts, des signaux de cadence de référence extrêmement constants (RS) sont envoyés au circuit de régulation de phase, que la température du quarts est réglée au moyen d'une commande externe du dispositif de chauffage ou de refroidissement (PE) aux échelons prédéterminés de la température du quartz, les tensions déterminées de commande de l'oscillateur à quarts représentant les valeurs de compensation pour l'échelon respectivement prédéterminé de température du quartz, et que les valeurs de compensation sont mémorisées dans respectivement l'une des zones de mémoire associées à des températures prédéterminées du quartz.

7. Dispositif pour la mise en oeuvre du procédé suivant les revendications 1, 2, 3 ou 5, caractérisé par le fait que l'oscillateur à quarts (VCXO) commandé par la tension, l'élément Peltier (PE) et le capteur de température (TS) sont disposés dans un boîtier thermiquement isolé (G), que le dispositif de mesure de température (TS) et l'entrée (SSE) de commande de la tension de l'oscillateur à quarts (VCXO) sont

9

raccordés au moyen de dispositifs de conversion analogique/numérique (D/A) à un dispositif à processeur (PZE), auquel l'élément Peltier (PE) est raccordé par l'intermédiaire d'un dispositif d'adaptation (AF), et que la sortie (A) de l'oscillateur à quarts est raccordée par l'intermédiaire d'un premier dispositif diviseur (T1) à un dispositif de comparaison de phase (PV) raccordé au dispositif à processeur (PZE), tandis que les signaux de cadence de référence (rs) sont envoyés à ce dispositif comparateur de phase par l'intermédiaire d'un second dispositif diviseur (T2).

# FIG 1

# FIG 2